# EUROPEAN PATENT APPLICATION

(11) **EP 3 376 290 A1**
(43) Date of publication of application: **19.09.2018**
(21) Application number: 17160879.7
(22) Date of filing: 14.03.2017
(51) Int. Cl.: G03F 9/00

(54) **METROLOGY METHOD AND METHOD OF DEVICE MANUFACTURE**

(71) Applicant: ASML Netherlands B.V., 5500 AH Veldhoven (NL)
(72) Inventor: VAN GORP, Simon Hendrik Celine, 5500 AH Veldhoven (NL); THUIJS, Koen, 5500 AH Veldhoven (NL); LUIJTEN, Carlo Cornelis Maria, 5500 AH Veldhoven (NL); STAALS, Frank, 5500 AH Veldhoven (NL)
(74) Representative: Peters, John Antoine

(57) **Abstract**

A method of measuring the topography of a substrate having device features thereon, the method comprising:
providing a coating on the substrate above the device features, the coating being substantially opaque to radiation of a predetermined wavelength;
applying a radiation-sensitive layer on the coating;
exposing the radiation-sensitive layer using a lithographic apparatus to define a plurality of focus-sensitive targets; and
measuring a parameter of the focus-sensitive targets using a radiation beam having the predetermined wavelength to determine information describing the topography of the substrate.

## Description

### BACKGROUND

### Field of the Invention

The present invention relates to device manufacturing and in particular to a method for measuring the topology of a substrate having device patterns thereon.

### Background Art

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned.

In lithographic processes, it is desirable to measure the topography of a substrate which is to be, or has been, exposed to form device patterns thereon. Prior to exposure, it is useful to know the topography of the substrate so that it can be positioned properly so that the exposure is in focus. After exposures it is useful to know the topography of the substrate to monitor the device manufacturing process and verify that device patterns have been correctly formed.

Certain forms of device, such MEMS and 3D NAND structures, involve structures with large height variations. These large height variations cause stress and hence distortions in the substrate. At the same time, processes to form this type of structure often have very tight limits on focus errors, requiring the substrate to be positioned very accurately during exposures. However the height variations of these structures can cause errors in the measurements of a level sensor that is used

### SUMMARY OF THE INVENTION

The present invention aims to improve yield in a lithographic device manufacturing process.

The invention in a first aspect provides a method of measuring the topography of a substrate having device features thereon, the method comprising:
providing a coating on the substrate above the device features, the coating being substantially opaque to radiation of a predetermined wavelength;
applying a radiation-sensitive layer on the coating;
exposing the radiation-sensitive layer using a lithographic apparatus to define a plurality of focus-sensitive targets; and
measuring a parameter of the focus-sensitive targets using a radiation beam having a wavelength spectrum including at least the predetermined wavelength to determine information describing the topography of the substrate.

The invention in a second aspect provides a method to provide a focus sensitive target to a mask, the method comprising: determining a location on the mask to which the focus sensitive target will be provided based on a layout of features on a substrate.

### BRIEF DESCRIPTION OF THE DRAWINGS/FIGURES

Embodiments of the invention will now be described, by way of example, with reference to the accompanying drawings in which:
Figure 1 depicts a lithographic apparatus together with other apparatuses forming a production facility for semiconductor devices;
Figure 2 is a flow chart of a method according to an embodiment of the invention;
Figure 3 depicts a part of a substrate on which a method of the invention is performed;
Figure 4 depicts the part of a substrate of Figure 3 at an intermediate stage in a method of the invention; and
Figure 5 is an enlarged view of the part of the substrate at an end stage in a method of the invention.

### DETAILED DESCRIPTION

Before describing embodiments of the invention in detail, it is instructive to present an example environment in which embodiments of the present invention may be implemented.

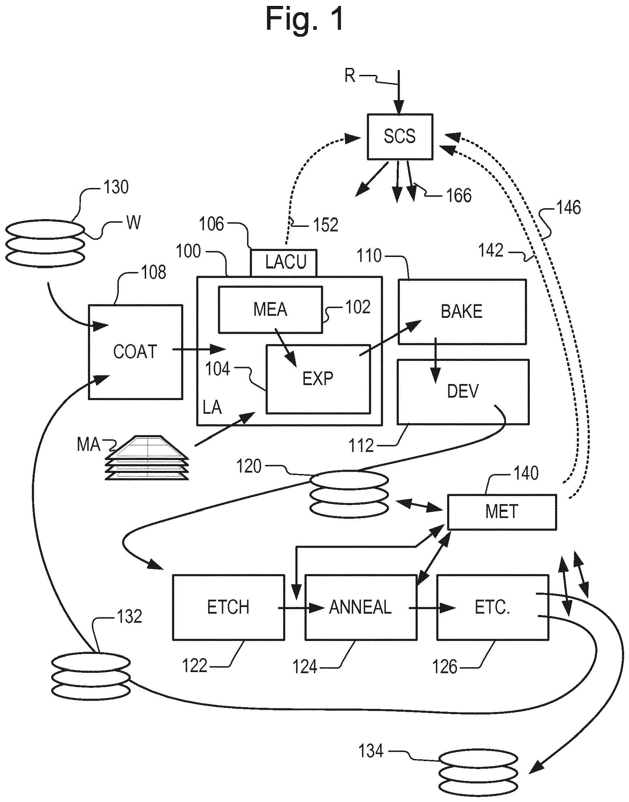

Figure 1 illustrates a typical layout of a semiconductor production facility. A lithographic apparatus 100 applies a desired pattern onto a substrate. A lithographic apparatus is used, for example, in the manufacture of integrated circuits (ICs). In that instance, a patterning device, which is alternatively referred to as a mask or a reticle, comprises a circuit pattern of features (often referred to as "product features") to be formed on an individual layer of the IC. This pattern is transferred onto a target portion (e.g., comprising part of, one, or several dies) on a substrate 'W' (e.g., a silicon wafer) via exposure 104 of the patterning device onto a layer of radiation-sensitive material (resist) provided on the substrate. In general, a single substrate will contain a network of adjacent target portions that are successively patterned.

Known lithographic apparatus irradiate each target portion by illuminating the patterning device while synchronously positioning the target portion of the substrate at an image position of the patterning device. An irradiated target portion of the substrate is referred to as an "exposure field", or simply "field". The layout of the fields on the substrate is typically a network of adjacent rectangles aligned in accordance to a Cartesian two-dimensional coordinate system (eg aligned along an X and an Y-axis, both axes being orthogonal to each other).

A requirement on the lithographic apparatus is an accurate reproduction of the desired pattern onto the substrate. The positions and dimensions of the applied product features need to be within certain tolerances. Position errors may occur due to an overlay error (often referred to as "overlay"). The overlay is the error in placing a first product feature within a first layer relative to a second product feature within a second layer. The lithographic apparatus minimizes the overlay errors by aligning each wafer accurately to a reference prior to patterning. This is done by measuring positions of alignment marks which are applied to the substrate. Based on the alignment measurements the substrate position is controlled during the patterning process in order to prevent occurrence of overlay errors.

An error in a critical dimension (CD) of the product feature may occur when the applied dose associated with the exposure 104 is not within specification. For this reason the lithographic apparatus 100 must be able to accurately control the dose of the radiation applied to the substrate. CD errors may also occur when the substrate is not positioned correctly with respect to a focal plane associated with the pattern image. Focal position errors are commonly associated with non-planarity of a substrate surface (also referred to as unflatness). The lithographic apparatus minimizes these focal positon errors by measuring the substrate surface topography using a level sensor prior to patterning. Substrate height corrections are applied during subsequent patterning to assure correct imaging (focusing) of the patterning device onto the substrate.

To verify the overlay and CD errors associated with the lithographic process the patterned substrates are inspected by a metrology apparatus 140. A common example of a metrology apparatus is a scatterometer. The scatterometer conventionally measures characteristics of dedicated metrology targets. These metrology targets are representative of the product features, except that their dimensions are typically larger in order to allow accurate measurement. The scatterometer measures the overlay by detecting an asymmetry of a diffraction pattern associated with an overlay metrology target. Critical dimensions are measured by analysis of a diffraction pattern associated with a CD metrology target. Another example of a metrology tool is an electron beam (e-beam) based inspection tool such as a scanning electron microscope (SEM).

Within a semiconductor production facility, lithographic apparatus 100 and metrology apparatus 140 form part of a "litho cell" or "litho cluster". The litho cluster comprises also a coating apparatus 108 for applying photosensitive resist to substrates W, a baking apparatus 110, a developing apparatus 112 for developing the exposed pattern into a physical resist pattern, an etching station 122, apparatus 124 performing a post-etch annealing step and possibly further processing apparatuses, 126, etc... The metrology apparatus is configured to inspect substrates after development (112) or after further processing (e.g. etching). The various apparatus within the litho cell are controlled by a supervisory control system SCS, which controls the lithographic apparatus via lithographic apparatus control unit LACU. The SCS allows the different apparatuses to be operated giving maximum throughput and product yield. An important control mechanism is the feedback 146 of the metrology apparatus 140 to the various apparatus (via the SCS), in particular to the lithographic apparatus 100. Based on the characteristics of the metrology feedback corrective actions are determined to improve processing quality of subsequent substrates.

The performance of a lithographic apparatus is conventionally controlled and corrected by methods such as advanced process control (APC) described for example in US2012008127A1. The advanced process control techniques use measurements of metrology targets applied to the substrate. A Manufacturing Execution System (MES) schedules the APC measurements and communicates the measurement results to a data processing unit. The data processing unit translates the characteristics of the measurement data to a recipe comprising instructions for the lithographic apparatus. This method is very effective in suppressing drift phenomena associated with the lithographic apparatus.

The processing of metrology data to corrective actions performed by the processing apparatus is important for semiconductor manufacturing. In addition to the metrology data also characteristics of individual patterning devices, substrates, processing apparatus and other context data may be needed to further optimize the manufacturing process. The framework wherein available metrology and context data is used to optimize the lithographic process as a whole is commonly referred to as part of holistic lithography. For example context data relating to CD errors on a reticle may be used to control various apparatus (lithographic apparatus, etching station) such that said CD errors will not affect the yield of the manufacturing process. Subsequent metrology data may then be used to verify the effectiveness of the control strategy and further corrective actions may be determined.

An issue that is increasing in importance is substrate flatness (also referred to as planarity). In order to ensure that the whole of an exposed field is imaged in focus it is desirable that the substrate is flat to a high degree of precision. This is particularly important for certain types of device, including 3D NAND structures and MEMS structures, for which strict limits on substrate unflatness are set. However, devices such as these which are built up over the substrate create large height differences between certain features of the devices and other parts, such as the scribe lanes in which no product features are formed. These large height differences cause stresses in the substrate which can distort the substrate and increase unflatness. Also, the large height differences can cause errors in the measurements of a level sensor used to obtain a height map of the substrate. The height map is used to derive positioning set points to correctly position the substrate relative to the plane of best focus of the projection system of a lithographic apparatus during exposures. Thus errors in the measurements of the level sensor compound the difficulties of performing a correctly focused exposure on a substrate that may have significant unflatness due to large height differences.

One cause of errors in the measurements of a level sensor when measuring substrates with product features that have large height differences is that the level sensor may have a measurement spot that is significantly larger than the product features. Thus the level sensor measurements do not follow the height variations of the product features but average them in an unpredictable way.

Another cause of errors is that the wavelength of the radiation used by the level sensor may be comparable to spatial frequencies in the product features so that unpredictable optical effects, such as diffraction and interference, may affect the measurements.

Accordingly, the present invention proposes an alternative approach to measurement of topography on a substrate having device features. The present invention can provide more accurate results, especially when the device features involve large height variations. The topography of a substrate having device features can be regarded as made up of two components: the underlying substrate topography and the device topography which lies on top of the substrate topography. The present invention is able to measure both components and can be used to separate the substrate topography from the device topography. The device topography generally repeats from field to field, but may have variations. The present invention can be used to determine the constant device fingerprint as well as the field-to-field variations.

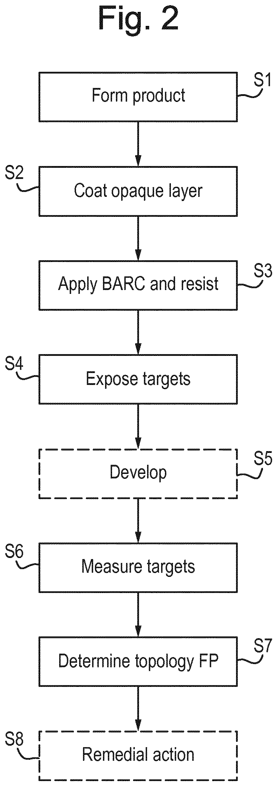

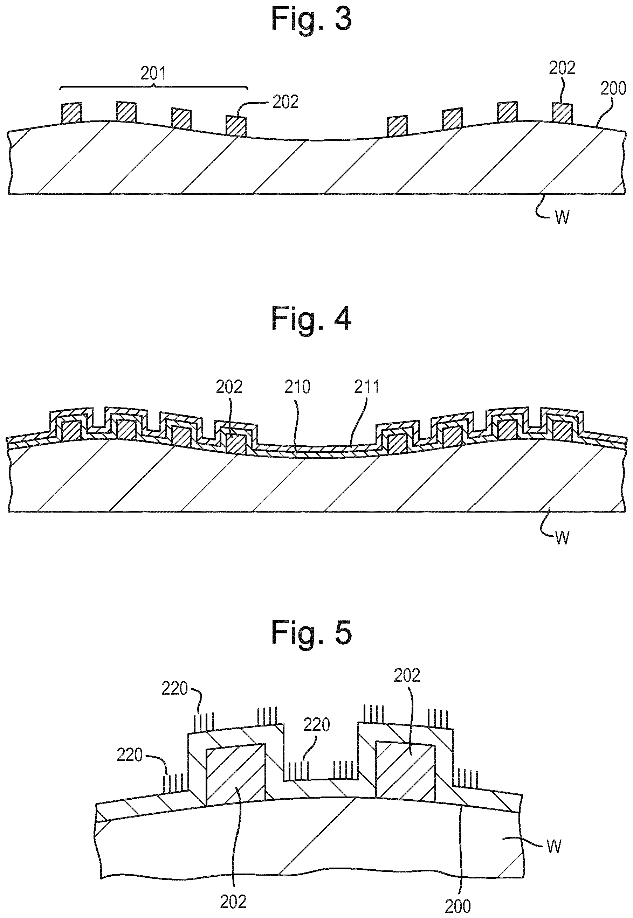

A method according to an embodiment of the invention is depicted in Figure 2. First product features are formed S1 on the substrate. This is depicted in Figure 3 which schematically represents a substrate W having an upper surface 200 which is non-flat, i.e. has a substrate topography. A field (or die) 201 includes a plurality of projecting features 202 which are superimposed on the substrate topography. Each field 201 has nominally the same pattern of device features 202 but the local substrate topography differs and there may be field-to-field variations in the device features, especially in fields that are adjacent the edge of the substrate (edge fields). Formation of the product features is performed by any suitable known technique and may include multiple expose-develop-process cycles.

Once the relevant product features have been formed, the substrate is coated S2 with an opaque layer 201 that covers the product features 202 and substantially conforms to their contour as shown in Figure 4. The opaque layer desirably has a thickness that is optimized to be thick enough to be opaque for certain wavelengths and to be small enough to prevent smearing out of the product topography. The opaque layer may be a metal, such as tungsten or carbon. It should be noted that the opaque layer is only required to be opaque to specific wavelengths and can have a non-zero transmissivity, as will be discussed below.

Above the opaque coating 210, a bottom anti-reflection coating (BARC) and a radiation sensitive layer 211 (e.g. a resist) are applied S3, as shown in Figure 4. Next, the radiation-sensitive layer is exposed in a lithographic apparatus to form a plurality of focus-sensitive targets. A focus-sensitive target is a target designed so that a property of an instance of the target formed on the substrate varies in a measureable and predictable manner according to the vertical position of the surface on which the instance of the target was exposed. A simple example of a focus-sensitive target is a grating whose duty ratio varies if printed out of focus. Other forms of focus-sensitive targets are known. The focus sensitive target may also be referred to as a focus marker. To expose the radiation-sensitive layer, a mask is used that comprises a dense grid of the chosen focus sensitive targets covering substantially the entire field.

One form of focus-sensitive target that can be used in an embodiment of the invention is described in US2016313656, which document is incorporated herein by reference in its entirety. The targets described in this document have alternating regions of two different structures. The two structures have different dependency on focus and are arranged so that a focus offset on exposure causes asymmetry in the target. The asymmetry may derive from variation in side wall angle. The asymmetry can be measured using, for example, a scatterometer. This method of measuring focus is sometimes referred to as diffraction-based focus (DBF) measurement.

Another type of focus marker that can be used in an embodiment of the invention is an astigmatism-based focus (ABF) marker, for example as described in US 20160363871 A1, which document is incorporated herein by reference in its entirety. An ABF marker is exposed onto the substrate with a deliberate astigmatism introduced into the projection system. The astigmatism can be created by one or more manipulators present in the projection system and normally used to reduce astigmatism. As a result of the astigmatism, a focus-dependent change is caused in the printed marker, for example horizontally-oriented features may be shifted relative to vertically-oriented features. An ABF marker can be measured using a scatterometer or a scanning electron microscope, for example.

Once the targets are exposed in the radiation-sensitive layers, the substrate is removed and the radiation-sensitive layer is developed S5 to reveal the markers. This step can be omitted if there is sufficient optical contrast between the exposed and un-exposed parts of the radiation-sensitive layer to allow measurement of the markers. After development, the situation depicted in Figure 5 is reached. As can be seen, targets 220 are present on top of projecting features 202, i.e. the highlands of the device pattern, and in the areas between the projecting features, i.e. the lowlands.

In an embodiment the targets 220 are provided as depicted in figure 5 by providing focus sensitive targets on the mask only at selected locations coinciding with either a position of a projecting feature 202 (highland) or a position between projecting features 202 (lowland). This has the advantage that the focus sensitive targets do not need to be provided as a dense grid of focus sensitive targets covering substantially the entire field. In an embodiment the focus sensitive targets are provided on a mask at a selection of locations chosen based on an expected layout of features provided to a substrate. The layout of features may be derived from any source of information associated with the patterning of the substrate, eg a mask layout file (GDS file).

Next, the targets are measured S6 using the relevant metrology tool, e.g. a scatterometer, a scanning electron microscope (SEM), or a CD inspection tool. The required opacity of the opaque layer is determined by the metrology tool used to measure the focus-sensitive targets 220. The opaque layer should be opaque to the wavelength(s) of radiation used by the metrology tool (working wavelengths) and may be in the visible, UV, DUV or EUV ranges. Depending on the metrology tool, the opaque layer may be required to be opaque to a broadband of radiation or only a narrow range of wavelengths. The opaque layer is desirably sufficiently opaque to suppress errors in the measurement of the metrology tool caused by reflection of the underlying structures, e.g. projecting features 220. Depending on the metrology tool, a non-zero transmissivity at the working wavelength(s) can be allowed. Note that the metrology tool used may determine a minimum transmissivity at specific wavelengths; the optical properties of the opaque layer at other wavelengths are largely irrelevant.

It should also be noted that a metrology tool may illuminate a target with a broadband source and have a filter in a measurement branch to select only one or more wavelengths for measurement. In such a case it may be sufficient for the opaque layer to be opaque to the wavelength(s) selected for measurement and not necessarily to all wavelengths of the illumination beam.

Information relating to the topology of the substrate is then determined S7 from the results of the measurements of the targets. In one embodiment, the focus errors obtained from the measurements are combined with knowledge of the vertical position of the substrate when each target was exposed onto the radiation-sensitive layer to obtain a height map of the substrate. The resolution and precision of the height map depends on the number of targets and their distribution on the substrate. Desirably targets are located in multiple fields of the substrate. Desirably at least one field contains multiple targets. In an embodiment each field of the substrate contains many targets so that a high resolution height map can be obtained. This is practical since the time taken to expose the targets onto the substrate does not increase with the number of targets per field. The measurement time is increased linearly with the number of targets but since the target measurement is performed off-line it does not affect throughput of the lithographic apparatus.

In an embodiment, the number and distribution of the focus-sensitive targets is sufficient to enable the topography of the underlying substrate and the device features at a micrometer scale. It is then possible to identify a device fingerprint, which substantially repeats per field, field-to-field variations of the device fingerprint and the underlying substrate topography. Known mathematical techniques can be used to decompose the complete height map into these components.

After determination of the topography, remedial action S8 is taken as desired. Exactly what remedial action is taken depends on the circumstances. For example if the present invention is used in development of a process for high volume manufacture of a device, the present invention may be used to adjust a parameter of the process or recipe for one or more layers of the device. The adjustment of the parameter may improve yield, for example. The adjusted recipe is applied to future manufacture.

In other cases, the present invention may be applied during high volume manufacture to monitor the manufacturing process. A change in the topography may be indicative of drift in a lithography process tool and so an adjustment of a parameter of the lithographic tool, or another tool used in the process, may be made as the remedial action. During high volume manufacture, the present invention may be applied to only a sample of the substrates.

In most cases, substrates to which the present invention are not suitable for further processing and may be scrapped or used for further tests. However, if the opaque layer and focus-sensitive targets can be removed without damage to the underlying product structures then the substrate can be returned to the manufacturing process.

While specific embodiments of the invention have been described above, it will be appreciated that the invention may be practiced otherwise than as described.

An embodiment may include a computer program containing one or more sequences of machine-readable instructions configured to instruct various apparatus as depicted in Figure 1 to perform measurement and optimization steps and to control a subsequent exposure process as described above. This computer program may be executed, for example, within the control unit LACU or the supervisory control system SCS of Figure 1 or a combination of both. There may also be provided a data storage medium (e.g., semiconductor memory, magnetic or optical disk) having such a computer program stored therein.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams. Implementations of scatterometers and other inspection apparatus can be made in UV and EUV wavelengths using suitable sources, and the present disclosure is in no way limited to systems using IR and visible radiation.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

## Claims

1. A method of measuring the topography of a substrate having device features thereon, the method comprising:
providing a coating on the substrate above the device features, the coating being substantially opaque to radiation of a predetermined wavelength;
applying a radiation-sensitive layer on the coating;
exposing the radiation-sensitive layer using a lithographic apparatus to define a plurality of focus-sensitive targets; and
measuring a parameter of the focus-sensitive targets using a radiation beam having a wavelength spectrum including at least the predetermined wavelength to determine information describing the topography of the substrate.

2. A method according to claim 1 wherein the measuring is performed using a scatterometer, a scanning electron microscope or a CD inspection tool.

3. A method according to claim 1 wherein the focus-sensitive targets are smaller than at least one of the device features.

4. A method according to claim 3, wherein the device features include projecting features and some of the focus-sensitive targets are located on top of the projecting features and/or between the projecting features.

5. A method according to any one of the preceding claims wherein the substrate has a plurality of fields and the exposing defines a plurality of focus-sensitive targets in at least one field.

6. A method according to any one of the preceding claims wherein the substrate has a plurality of fields and the exposing defines at least one focus-sensitive target in each of a plurality of fields.

7. A method according to any one of the preceding claims further comprising developing the radiation-sensitive layer before the measuring.

8. A method according to any one of the preceding claims wherein the substrate has a plurality of fields and the information describes an intra-field topography fingerprint.

9. A method according to any one of the preceding claims wherein the substrate has a plurality of fields and the information describes an inter-field topography fingerprint.

10. A method according to any one of the preceding claims further comprising using the information to adjust a parameter of a recipe for manufacture of devices having the device features.

11. A method according to any one of the preceding claims further comprising using the information to infer a property of other substrates having the device features.

12. A method according to any one of the preceding claims further comprising using the information to infer a property of a lithographic apparatus and/or process used to form the device features.

13. A method to provide a focus sensitive target to a mask, the method comprising: determining a location on the mask to which the focus sensitive target will be provided based on a layout of features on a substrate.

14. A method according to claim 13, wherein the features are device features.

15. A method according to claim 13 or 14, wherein the layout of features is derived from a mask layout file.
